# EUROPÄISCHE PATENTSCHRIFT

(11) **EP 1 525 609 B1**
(45) Veröffentlichungstag und Bekanntmachung des Hinweises auf die Patenterteilung: **26.11.2008**
(21) Anmeldenummer: 03787731.3
(22) Anmeldetag: 24.07.2003
(51) Int. Cl.: H01L 21/00, H01L 21/3063

(54) **VORRICHTUNG ZUM AETZEN GROSSFLAECHIGER HALBLEITERSCHEIBEN**
DEVICE FOR ETCHING SEMICONDUCTORS WITH A LARGE SURFACE AREA
DISPOSITIF DE GRAVURE DE TRANCHES SEMI-CONDUCTRICES A GRANDES SURFACES

(30) Priorität: 31.07.2002 DE 10235020
(43) Veröffentlichungstag der Anmeldung: 27.04.2005
(73) Patentinhaber: Christian-Albrechts-Universität zu Kiel, 24118 Kiel (DE)
(72) Erfinder: CHRISTOPHERSEN, Marc, 24105 Kiel (DE); BAHR, Jörg, 24161 Altenholz (DE); CARSTENSEN, Jürgen, 24143 Kiel (DE); STEEN, Kay, 24106 Kiel (DE); POPKIROV, Georgi, 24107 Kiel (DE); FÖLL, Helmut, 24248 Mönkeberg (DE)
(74) Vertreter: Biehl, Christian
(86) Internationale Anmeldenummer: PCT/DE2003/002491
(87) Internationale Veröffentlichungsnummer: WO 2004/017384

(56) Entgegenhaltungen:
- EP-A- 0 853 332
- US-A- 5 374 325
- US-B1- 6 235 147
- PATENT ABSTRACTS OF JAPAN vol. 011, no. 108 (E-495), 4. April 1987 (1987-04-04) & JP 61 255028 A (TOKUJI ARAI), 12. November 1986 (1986-11-12)

## Beschreibung

Die Erfindung betrifft ein Vorrichtung zum Ätzen großflächiger Halbleiterscheiben. Für eine Vielzahl neuartiger Produkte oder Bearbeitungsschritte im Bereich der Halbleitertechnologie ist es vorteilhaft oder unumgänglich, neben chemischen insbesondere auch elektrochemische Ätzmethoden einzusetzen. Dies gilt insbesondere für die Herstellung einer großen Vielfalt an Poren in z.B. Silizium, GaAs, InP oder GaP, die nur durch elektrochemische Methoden herstellbar sind.

In der Regel wird für ein solches Ätzen ein anodischer Strom durch den Halbleiter geführt (d.h. Pluspol der Stromquelle am Halbleiter), der am Übergang Halbleiter - Elektrolyt eine chemische Reaktion induziert, die zur Auflösung des Halbleitermaterials führt. Die zu erzeugende Struktur, beispielsweise sog. Makroporen mit Durchmessern im Bereich von 1 µm und Tiefen von einigen 100 µm, soll dabei auf der gesamten Halbleiteroberfläche homogen sein; darüber hinaus ist ein einfacher, sicherer und schneller Prozeß äußerst wünschenswert.

Elektrochemische (Poren)ätzung in Silizium findet typischerweise Anwendung in Technologiefeldern wie
- Mikroelektronik und Mikrosystemtechnik,
- Biotechnologie; z.B. Biochips oder Biosensoren,
- Sensorik ganz allgemein,
- Herstellung von sog. SOI (Silicon On Insulator) Wafern,
- Herstellung von photonischen Kristallen, speziellen Filtern und Elementen der Quantenoptik bzw. nichtlinearen Optik,
- Solarik (z.B. zur Herstellung von Antireflexschichten),
- Brennstoffzellen (als poröse Elektrode),
- Nanotechnik; z.B. bei der Herstellung von Nanodrähten.

Diese Anwendungen bringen Anforderungen mit sich, die für großflächige Halbleiterscheiben - z.B. Silizium-Wafer mit Durchmessern von 300 mm - nur sehr schwer zu erfüllen sind; selbst für kleinere Proben mit Flächen im Bereich einiger cm² ist eine homogene Ätzung nicht ohne weiteres zu erreichen. Die Schwierigkeiten resultieren aus der Kombination mehrerer Besonderheiten, die bei Flächen größer als einige wenige cm² in Summe sehr schnell an die Grenzen üblicher Ätzzellen führen. Insbesondere folgende Faktoren sind kritisch und müssen beachtet werden:
- Homogener Hin- und Rücktransport des Elektrolyten zur reaktiven Grenzfläche. Bei einfachen elektrolytdurchspülten Zellen wird das Strömungsmuster des Elektrolyten immer Inhomogenitäten der Ätzung verursachen.
- Homogener elektrischer Kontakt zur Rückseite des Halbleiters. Dieser Kontakt muß in der Lage sein, große Ströme zu tragen. Bei Ätzstromdichten im Bereich von bis zu 100 mA/cm² ergeben sich bei typischen Si-Wafern mit Flächen im Bereich von 100 cm² Gesamtströme von 10 A und mehr, die zu elektrischen und thermischen Problemen führen können.
- Möglichkeit der homogen Beleuchtung der Rückseite mit Licht hoher Intensität. Dies ist für mehrere Anwendungszwecke erforderlich.
- Kontrolle der Temperatur in engen Grenzen (ohne Beeinflussung des optimierten Strömungsverhaltens).
- Absolute Dichtigkeit sowohl der Scheibenhalterung als auch der gesamten Apparatur.
- Kein Scheibenbruch, auch nicht bei Proben, die durch die Ätzung hochporös und damit mechanisch sehr anfällig geworden sind.
- Beständigkeit aller Materialien, die mit dem Elektrolyt benetzt werden, gegenüber äußerst aggressiven Chemikalien (z.B. Gemische von HF und organischen, hochpolaren Lösungsmitteln).
- Gefahrlose Entfernung großer Mengen an Gasen, die bei der Ätzung entstehen können (in der Regel H₂ und O₂, aber u.U. auch die extrem giftigen Gase PH₃, AsH₃).
- Verwendbarkeit für Halbleiter aller Arten, z.B n- und p-dotiertes Silizium, GaAs, InP usw.

Als Stand der Technik sind die japanischen Patentveröffentlichungen PATENT AB-STRACTS OF JAPAN Bd. 11, Nr. 108 (E-495) & JP 61 255 028 A zu nennen, in der eine Vorrichtung zum Ätzen des Halbleitersubstrats beschrieben wird, die mit zwei Stangen ein Reaktionsgefäß bewegt, und weiter die US-B1 6,235,147, die eine Vorrichtung zum Ätzen von Halbleitern mit einer Hochdruck-Sprüheinrichtung beschreibt.

Schließlich sind in den Schriften EP-A 0 853 332 und US-A 5,374,325 Vorrichtungen zum Ätzen von Halbleitersubstraten beschrieben, bei denen ein aufwendiges Umwälzverfahren einen gleichmäßigen Fluidaustausch auf der Ätzoberfläche gewährleisten soll.

Die Erfindung ermöglicht Ätzen mit den o.a. Randbedingungen mit einer Vorrichtung mit den Merkmale des Hauptanspruchs, die all die vorgenannten Anforderungen erfüllt. Die Unteransprüche geben vorteilhafte Ausführungsformen wieder.

Im folgenden wird nun beispielbaft für alle Anwendungen nur noch die Anwendung zur Makroporenätzung in dem Halbleiter Silizium besprochen, vorzugsweise für p-dotiertes Silizium bei dem die o.g. Anforderungen am schwersten zu befriedigen sind. Die Übertragung auf andere Porensorten (z.B. Mikro- und Mesoporen) und Halbleiter, insbesondere aus der Gruppe der III-V Verbindungen, ist dann grundsätzlich möglich, wobei allenfalls triviale Änderungen, die Stand der Technik sind (z.B. Verwendung anderer Elektrolyten oder andere Geometrie der Proben) erforderlich werden. Außerdem ist die Anwendung auf Nichthalbleiter ebenfalls möglich.

Mit der erfindungsgemäßen Vorrichtung kann auch eine galvanische Abscheidung (Beschichtung) vorgenommen werden. Die spezifischen Vorteile der Erfindung bestehen außer in der Erfüllung der w.o. bereits genannten Punkte aber insbesondere in folgenden speziellen Punkten:
1. Beständigkeit gegenüber Elektrolyten, die außer der für die Si-Ätzung immer benötigten Flußsäure (HF) auch aggressive organische Lösungsmittel wie z.B. Acetonitril, Dimethylformamid, Formamid, Dimethylsulfoxid, Hexamethylphosphorsäuretriamid oder Dimethylacetamid enthalten. Diese Chemikalien greifen nicht nur die meisten üblichen Kunststoffe an, sondern auch Hilfsmaterialien wie sog. Weichmacher in den Kunststoffen, Kleber, Schläuche oder O-Ringe.
2. Homogene Ätzung bzw. Strömungsmuster für viele verschiedene Sorten von Elektrolyten mit zum Beispiel verschiedenen Viskositäten.
3. Leichte Anpassung des Probenhalters an Proben verschiedenster Größe und Geometrie ohne Verlust der Homogenität.
4. Variabilität bei der Rückseitenkontaktierung; Beleuchtung der Rückseite als Option.
5. In-Situ Kontrolle aller Ätzparameter.

Die neuartigen Vorrichtung realisiert dies dabei insbesondere durch die Realisierung folgender Punkte:
i. Komplette Trennung von Ätztrog und "Probenkopf'
ii. Möglichkeit für den Betrieb mit der zu ätzenden Seite nach unten (Normalfall).
iii. Herstellung homogener Ätzbedingungen durch (im zeitlichen Mittel) homogene Elektrolytströmung; realisiert durch leicht steuerbare Kippbewegungen von Probenkopf und Ätztrog.
iv. Herstellung von Probenkopf und Ätztrog aus je einem Stück geeigneten Materials (z.B. PTFE; Handelsname meist Teflon^{®}). Damit ist absolute Auslaufsicherheit gewährleistet
v. Kontaktierung der Rückseite wahlweise durch Randkontakte, ganzflächige Metallkontakte (insbesondere nutzbar bei Proben mit metallisierter Rückseite), durch eine mit "ITO" (= Indium Zinn Oxid; ein durchsichtiger Leiter) beschichtete Glasplatte oder eine mit feinen Platin-Drähten umwickelte Plexiglasplatte, um Rückseitenbeleuchtung zu ermöglichen.
vi. Kontrolle der Elektrolytqualität (mit den Parametern Temperatur, gelöste Gase, Konzentrationen der Komponenten) und der Ätzparameter (Spannung, Strom, Beleuchtungsintensität; aber auch z.B. Impedanz); Verarbeitung durch geeignete Software und entsprechende "real-time" Regelung.

Dabei besteht die Vorrichtung zum Ätzen großflächiger Halbleiterscheiben aus einer trogförmigen Aufnahme mit einem flüssigen Elektrolyten, wenigstens einem Probenkopf, der innerhalb des beweglich gelagerten Ätztrogs vorgesehen, mit einer Einrichtung zum Halten wenigstens einer Halbleiterscheibe (einem Wafer) versehen ist.

Dabei wird der Probenkopf am Ätztrog befestigt, während der Ätztrog zur Durchfiihrung von Kippbewegungen um wenigstens eine Achse verschwenkbar ist. Auf eine Kippbewegung kann verzichtet werden, wenn der Kopf horizontal im Becken vor und zurückbewegt wird, so daß sich ein ähnlicher Elektrolytstrom wie durch die Kippbewegung bildet. Zur Verbesserung der turbulenten Strömung des Elektrolyten wird vorgeschlagen, Kanäle am Boden des Ätztrogs und/oder an der Unterseite des Probenkopfes vorzusehen.

Bevorzugt wird jedoch, daß der Probenkopf am verkippbaren Ätztrog mit diesem beweglich über austauschbare Abstandsstücke gelagert ist, zur Einstellung unterschiedlicher Elektrolyt-Schichtdicken an der an der Unterseite des Probenkopfs über dem darunterliegenden Boden des Ätztrogs mit der zu ätzenden Seite nach unten gehalterten Halbleiterscheibe.

Zur Halterung der teilweise äußerst zerbrechlichen Halbleiterscheiben bei Ermöglichung einer rückseitigen Beleuchtung wird vorgeschlagen, am Probenkopf einen austauschbaren Montageblock oberhalb der Halbleiterscheibe anzuordnen, der mit Randfugen versehen ist, die über eine Vakuumleitung evakuierbar sind und die gegenüber dem Elektrolyten durch Ringdichtungen am Randbereich der Halbleiterscheibe abgedichtet sind. Um eine Beleutung der Halbleiterscheibe zu ermöglichen sollte der Montageblock bevorzugt optisch durchlässig sein und an seiner Oberseite oberhalb einer gegen das den Montageblock umgebenden Vakuums abdichtenden durchsichtigen Platte ein Diodenarray als Beleuchtung angeordnet sein.

Zur Vermeidung von leckageanfälligen Durchführungen wird vorgeschlagen, die Kontaktierung mit einer großflächigen Platinelektrode am Boden des Ätztrogs vorzunehmen, die mit Platindrähten, die an der Innenseite des Ätztrogs aufsteigen über dessen Kante führen, kontaktiert ist. Die Halbleiterscheibe wird an ihrer (Ober-) Rückseite über Randkontakte, ganzflächige Metallkontakte, durch eine mit ITO (Indium-Zinn-Oxid) beschichtete Glasplatte oder eine mit feinen Platindrähten umwikkelte Plexiglasplatte kontaktiert.

Dabei kann wenigstens eine Temperatursteuerung zur Erwärmung und/oder Abkühlung des Elektrolyten mit Kühl-/ Heizkanälen an der Unterseite des Ätztrogs vorgesehen sein. Auch kann zur Ausbildung einer Schutzgasatmosphäre über dem Elektrolyten der Ätztrogs, bzw. der Ätzkopf mit einem Deckel und mit Zu- und Abführungen für Schutzgas versehen sein.

Beim durch Erzeugen einer turbulenten Anströmung für die jeweils unterschiedlich viskosen Elektrolyte wird vorgeschlagen, eine an die zu ätzenden Halbleiterscheiben angepasste Bewegung des Ätztrogs und eine Einjustierung des Abstands Halbleiterscheibe zum Ätztrogboden über das vorherige Einsetzen geeigneter Abstandsstücke zwischen diesen vorzunehmen.

Zum Ausgleich der sich verbrauchende Säuren im Elektrolyten wird vorteilhafterweise während der fortschreitenden Ätzung hochkonzentrierter Elektrolyt zur Beibehaltung der Elektrolytkonzentration zugegeben.

Weitere Vorteile und Merkmale der Erfindung werden im folgenden anhand der beigefügten Zeichnung erläutert. Dabei zeigt:
**Fig. 1** schematisch den Aufbau der Vorrichtung,
**Fig. 2** den Ätztrog,
**Fig. 3** den Probenkopf mit Probenkammer, und

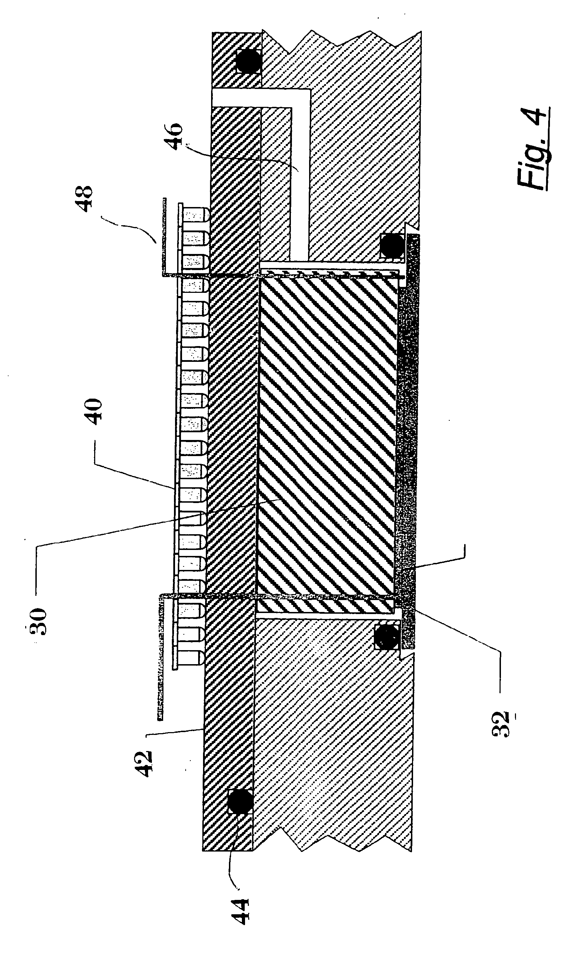

**Fig. 4** eine Detaildarstellung der Beleuchtung der Probenrückseite.

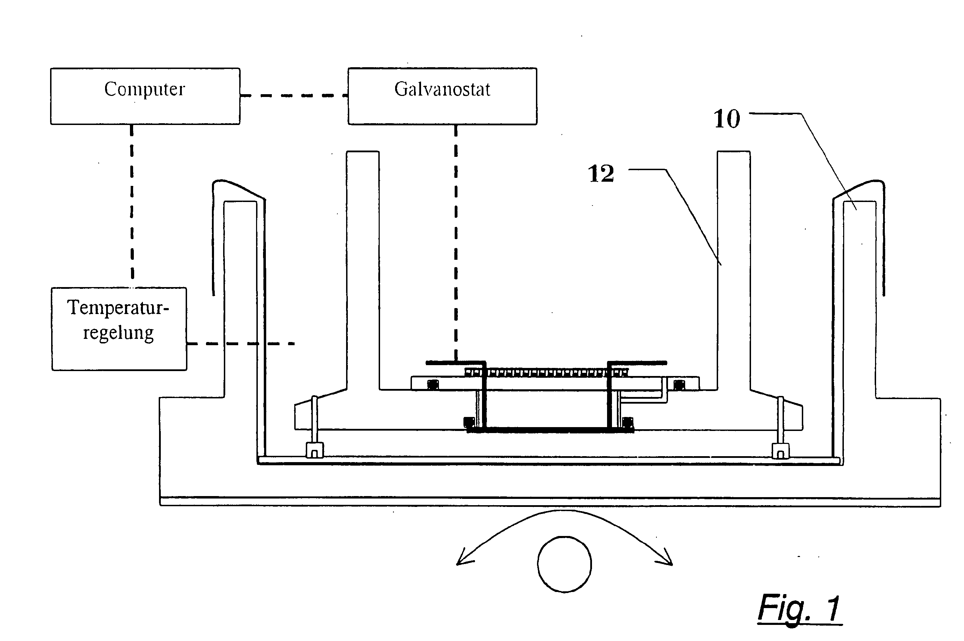

Fig. 1 zeigt die Grundkomponenten, den Ätztrog **10** und den Probenkopf **12.** Zwischen diesen wird der Elektrolyt **14** eingebracht. Die gesamte Anordnung ist auf einer um eine horizontale Achse drehbare Halterung montiert; im Betrieb wird eine Schaukelbewegung mit einem Gesamtwinkel von (5° - 25°) und einer Kippfrequenz von ca. 0.25 Hz (allgemeiner: zwischen 0 und 2 Hz) durchgeführt, wodurch der Elektrolyt sehr effektiv umgewälzt wird und homogene Ätzung auch großer Flächen sehr einfach zu erzielen ist.

Für den Betrieb wird somit keine Pumpe benötigt, die mit entsprechend hoher Pumpleistung den Elektrolyten umwälzen müßte. Damit sind Anschlußstutzen, Ventile, Schläuche usw., die erheblichen mechanischen Belastungen und den aggressiven Elektrolyten ausgesetzt sind, ebenfalls nicht erforderlich. Weiterhin erzeugen fast alle Pumpen Druckstöße, die zu einer zeitlich inhomogenen Ätzung führen können. Probleme in Bezug auf möglicherweise notwendige Druckminderer und -dämpfer treten somit ebenfalls nicht auf. Bei Nutzung einer Pumpe muß der Elektrolyt von Pumpenanschlußstutzen zum Wafer durch geeignete Führung aufgefächert werden. Dies erübrigt sich ebenfalls durch obiges Design. Insbesondere wird aber die Betriebssicherheit der Vorrichtung sehr stark erhöht, da der Elektrolyt nur Teflon "sieht". Leckagen durch Undichtigkeiten, Brüche etc., die bei den oft äußerst korrosiven, entzündlichen und giftigen Elektrolyten potentiell große Gefahren verursachen können, sind prinzipiell nicht möglich.

Die Temperatur des Elektrolyten **14** wird konstant gehalten und ist auf 0.1 °C einstellbar sowie während der Ätzung gezielt veränderbar. Die Geometrien des Ätztrogs **10** und des Probenkopfs **12** werden im folgenden beschrieben :

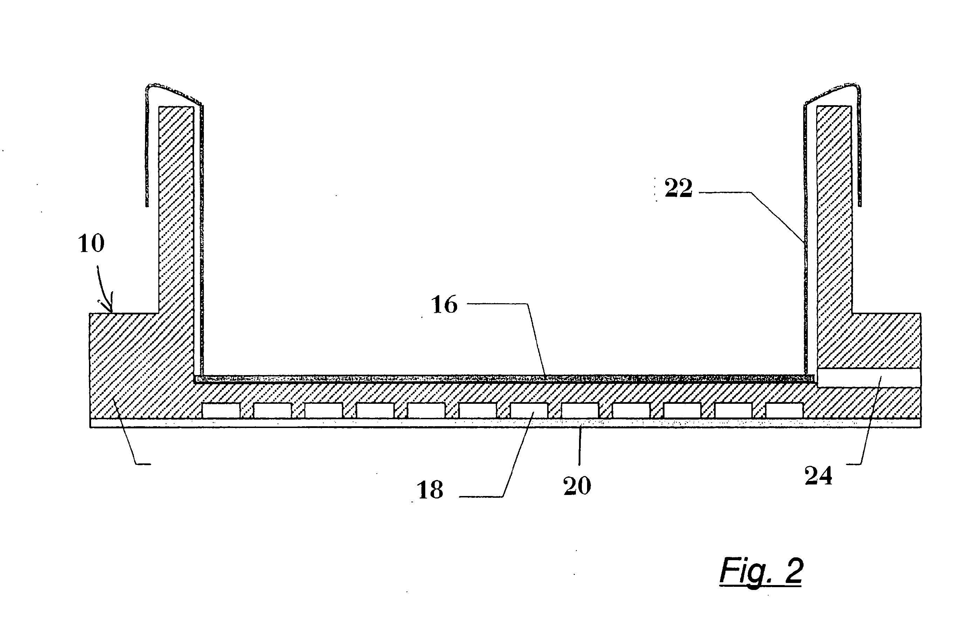

In Fig. 2 ist der aus einem Block Teflon gefertigte Ätztrog **10** dargestellt. Er gewährleistet selbst bei aggressivsten Elektrolyten Auslaufsicherheit und Beständigkeit. Eine großflächige Gegenelektrode **16** aus vorzugsweise Platin ist am Boden des Ätztrogs **10** eingebaut. Die Trogunterseite ist weiter mit eingefrästen Kanälen **18** versehen, die nach Verschluß mit z.B. einer Aluminium-Platte **20** eine Temperierung des Elektrolyten durch eine umlaufende Temperierflüssigkeit erlauben. Anschlüsse **22** aus Platindraht für die Platin-Gegenelektrode **16** sind über den Rand geführt, so daß Bohrungen und Dichtungen vermieden sind. Mit Bezugszeichen **24** ist ein Zu- und Ablauf für die Elektrolytflüssigkeit dargestellt.

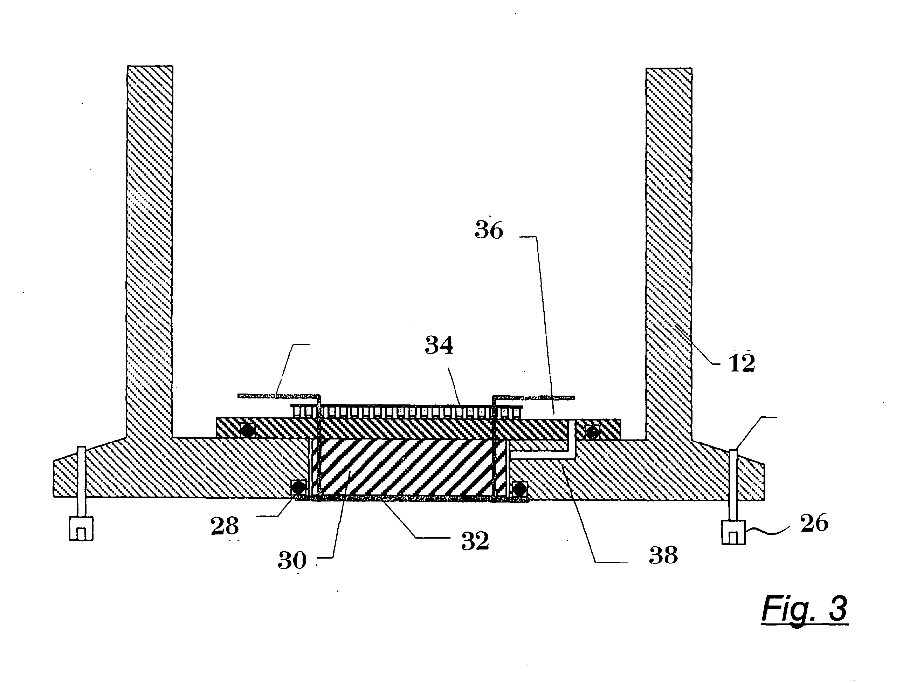

Der in Fig. 3 dargestellte Probenkopf **12** wird nun als das Herzstück der Vorrichtung mit der zu ätzenden Fläche nach unten in den Ätztrog eingebracht. Der Abstand Ätztrogboden - Probenkopf kann dabei in einfachster Weise durch Abstandsstücke **26** variiert werden. Diese Anordnung zusammen mit der Schaukelbewegung der gesamten Vorrichtung gewährleistet die Einhaltung der entscheidenden (insbesondere Strömungs-)Parameter beim Ätzen.

Der Probenkopf **12** ist ebenfalls aus einem Block Teflon gefertigt, um selbst bei aggressivsten Elektrolyten Dichtigkeit und Beständigkeit zu gewährleisten.

Die Dichtung des Wafers erfolgt über zwei Dichtungsringe **28,** die an seiner Rückseite anliegen, wobei der Probenkopf **12** zur Beherbergung der Dichtungsringe **28** neben einer Probenkammer **30** mit einer umlaufenden Kerbe versehen ist. Der zum Halten des Wafers **32** erforderliche Anpreßdruck kann durch Evakuieren der Probenkammer **30** mit einem Vakuumsystem (nicht dargestellt) am Anschluß **38** erzeugt werden.

Da hier bei z.B. im Fall des Bruchs der Probe Elektrolyt in das Vakuumsystem gesaugt werden kann, ist vorsorglich im Vakuumsystem ein elektrolytbeständiger Auffangbehälter eingebaut.

Temperatursensoren und Referenzelektroden (nicht gezeigt) sind möglichst nahe an dem Wafer angebracht, um verläßliche Werte für die Regelung zu erhalten.

Die elektrische Kontaktierung des Wafers erfolgt großflächig über die Rückseite. Dabei sind verschiedene Optionen möglich :
i) Kontaktierung der Probe (i.d.R. - aber nicht notwendigerweise - ein runder Wafer) durch eine geeignete Metallplatte oder Folie, z.B. Aluminium, mittels eines z.B aus PVC gefertigten Montageblockes mit Hilfe des Vakuums in der Probenkammer. Der äußere Anschluß erfolgt durch einen oder mehrere Drähte, die vom Rand der Metallplatte nach außen geführt werden.

Diese Kontaktierung ist für alle Proben geeignet, die über eine gut leitende Rückseite verfügen und keine Rückseitenbeleuchtung benötigen.
ii) Kontaktierung der Probe **32** so, daß Beleuchtung der Rückseite möglich wird. Dazu wird anstelle der Metallplatte und einem Montageblock entweder eine mit ITO (Indium-Zinn-Oxid) beschichtete Glasplatte oder eine aus durchsichtigem Kunststoff (z.B. Plexiglas®, PMMA) oder Glas gefertigte, mit feinen Platindrähten umwickelte Kontaktplatte eingesetzt. Die Umwicklung ist so vorzunehmen, daß die Transparenz nicht nennenswert behindert wird. Ein Leuchtdiodenarray **40** über der (jetzt durchsichtigen) Abschlußplatte 42 ermöglicht intensive und homogene Beleuchtung.

Alternativ dazu ist auch eine Kontaktierung nur des Randes der Probe durch Kontaktnadeln möglich. Dies ist aber i.d.R. nachteilig, da die Homogenität des Stromflusses dann schwerer zu erreichen ist.

Die Vorrichtung wird komplettiert durch :
- Einen leistungsfähigen Potentiostat und/oder Galvanostat, der die erforderlichen relativ hohen Spannungen und Ströme liefern kann und der vom zentralen Meßrechner aus gesteuert werden kann.
- Eine Pumpeinheit mit genügend großem Durchsatz (ca. 30 l/min) für die Vakuumansaugung.
- Eine "Wulfsche Flasche" (aus elektrolytbeständigem Material) die in das Vakuumsystem integriert ist, damit die aggressiven Elektrolyten auch bei einem Waferbruch nicht in die Vakuumpumpe oder in die Umgebung gelangen können.
- Eine Temperatureinheit, die erlaubt über ein Wärmetauscherprinzip die Elektrolytemperatur auf mindestens +/-0.2 °C konstant zu halten; bei einer Temperaturvorgabe die im Bereich von ca. -10 °C - +40 °C liegt. Die Einheit muß ebenfalls vom zentralen Rechner aus steuerbar sein.
- Eine Einheit zur Durchführung der Schaukelbewegung; entweder ein handelsüblicher Wipptisch oder eine einfache hydraulische / mechanische / pneumatische Vorrichtung.
- Einen Rechner, der die Vorrichtung steuert.
- Entsprechende Software.
- Eine optional (über den Meßrechner steuerbare) Lichtquelle zur Rückseitenbeleuchtung der Probe. Diese Lichtquelle wird vorzugsweise, aber nicht notwendigerweise durch eine Leuchtdiodenmatrix dargestellt.
- Die durchsichtigen Kontaktplatten aus mit Indium Zinn Oxid (ITO) beschichtetem Glas oder mit feinen PT-Drähten umwickelten durchsichtigem Material.
- Ein in den Zellkopf integriertes System von Bohrungen, über die Schutzgase in den Elektrolyten eingeleitet werden können (z.B zum "Stickstoffbubbeln" um gelösten Sauerstoff auszutreiben).

Entscheidend für eine homogene Ätzung über große Flächen ist die Homogenität der Stromzuführung und der Elektrolytströmung. Die Homogenität der Stromzuführung wird durch die beschriebenen Kontaktierungsverfahren gewährleistet, schwieriger zu erzielen ist die Homogenität der Elektrolytströmung im zeitlichen Mittel.

Im Gegensatz zu bekannten Ätzverfahren, in denen Elektrolytflußhomogenität nur für einen festen Parametersatz (insbesondere feste Probengröße) und nur nach langwierigem iterativem Optimieren gewährleistet werden kann, ist die Vorrichtung nach der Lehre der Erfindung an verschiedenste Bedingungen leicht anpaßbar. Zur Optimierung der Strömungsverhältnisse bei einem gegebenen Parametersatz (z.B. temperaturabhängige Viskosität des Elektrolyten, Größe der zu ätzenden Scheibe (typischerweise zwischen 50 mm und 300 mm Durchmesser, Leitfähigkeit des Elektrolyten) kann der Kippwinkel, die Kippfrequenz und der Abstand Probenkopf - Ätztrogboden geeignet verändert werden, wobei die Homogenität der Strömung unmittelbar durch Beobachtung kontrolliert werden kann.

Dies erfolgt, indem anstelle der eigentliche Probe eine durchsichtige Scheibe montiert wird (unter Verwendung eines durchsichtigen Montageblocks), und dem Elektrolyten eine geringe Menge von Schwebeteilchen (z.B. Leitsilber) beigemengt wird. Die Strömungsverhältnisse sind dann deutlich sichtbar und können sehr schnell auf den jeweiligen Verwendungszweck optimiert werden. Für die Ätzung von p-Typ Silizium Scheiben mit spezifischem Widerstand im Bereich 0.001 - 50 Ωcm sowie mit 100 mm Durchmesser erweisen sich beispielsweise Kippwinkel 6° -25°, Kippfrequenzen 0.05-2 Hz und ein Elektrolytvolumen von 1-3 Liter als geeignet.

Die optimale Temperatur für eine Ätzung ist wichtig; sie muß je nach Material und gewünschter Porenart eingestellt werden. Eine Temperaturkonstanz von +/- 0.1 °C ist für manche Ätzungen erforderlich und kann nach der Lehre der Erfindung erreicht werden. Für besonders anspruchsvolle Ätzungen, z.B. Makroporen in p-Typ Silizium mit Tiefen > 100µm kann es erforderlich sein, die Temperatur während der Ätzung gezielt zu ändern. Für p-Silizium mit einem spezifischen Widerstand von 10 Ωcm, in das Makroporen mit Tiefen von 200 µm geätzt werden sollen, ist beispielsweise eine kontinuierliche Temperaturänderung von 20 °C auf 12 °C von Vorteil.

Für die meisten Anwendungen empfiehlt es sich, mit konstantem Strom zu ätzen. Der Potentiostat/Galvanostat muß dann in der Lage sein, die erforderliche Spannung zu liefern, die leicht die Größenordnung von 100 V erreichen kann.

Die gewünschten Parameter und evtl. ihre zeitliche Änderungen werden im Meßrechner programmiert; anschließend kann der Ätzvorgang beginnen.

Die zu ätzende Halbleiterscheibe sollte vorzugsweise über einen niederohmigen Rückseitenkontakt verzügen, der mit herkömmlicher Technik durch Implantation einer p⁺-Schicht in p-Typ Halbleiter bzw. n⁺-Schicht in n-Typ Halbleiter, gefolgt durch die üblichen Temper- und Metallisierungsschritte, wobei eine (nicht durchsichtige) Metallisierung allerdings nur bei Proben, die keine Rückseitenbeleuchtung benötigen; zumindest aber müssen die zu ätzenden Bereiche ausgespart sein.

Es empfiehlt sich, die Vorderseite der Probe zu reinigen; Reinigungsverfahren dazu sind in der Literatur zahlreich beschrieben.

Die Kontaktierung der Scheibenrückseite erfolgt wie oben beschrieben. In der Regel am besten bewährt haben sich dünne Metallfolien, die über den aus relativ weichem Kunststoff gefertigten Montageblock auf die Probe gepreßt werden. Dicke Metallplatten müssen sehr gut poliert werden um eine homogene Kontaktierung zu erhalten.

Entscheidende Bedeutung hat die Dicke des Montageblocks. Sie muß präzise so eingestellt werden, daß zwar einerseits eine gewisse Durchbiegung der Probe noch möglich ist um ausreichenden Anpreßdruck für die Dichtigkeit zu erzeugen, anderseits die Durchbiegung so begrenzt wird, daß ein Bruch der Probe auch im porösem Zustand verhindert wird. Die dazu nötigen Zahlenwerte hängen von Probenart und Probengröße ab, sind aber leicht ermittelbar.

Bei Verwendung von n-Typ Halbleitern mit großer Diffusionslänge (i.d.R. Si und Ge), für die Rückseitenbeleuchtung sinnvoll ist, wird eine Modifikation der Kontaktierung verwendet wie oben beschrieben. Auf die Rückseite der Halbleiterprobe wird z.B. eine mit ITO beschichtete Glasplatte fest aufgepreßt; die ITO Schicht wird am Rand kontaktiert. Über der Anordnung wird ein Leuchtdiodenarray plaziert, mit einer spektralen Strahlungsverteilung, die dem Halbleiter angepaßt ist, d.h. mit einem Frequenzmaximum leicht unterhalb der Absorptionskante des Halbleiters. Damit kann die Rückseite der Halbleiterscheibe wenigstens lokal beleuchtet werden.

Zur Einstellung einer konstanten Stromdichte wird jetzt vorzugsweise die Lichtleistung des Leuchtdiodenarrays angepaßt.

Die Halbleiterscheiben können auf der Vorderseite auch strukturiert sein, d.h. eine gegenüber dem verwendeten Elektrolyten resistente Maskierungsschicht besitzen. Der Ätzangriff ist dann auf die offenen Bereiche beschränkt; der Gesamtstrom muß so angepaßt werden, daß die Stromdichte in den ungeschützten Bereichen den gewünschten Wert erreicht.

Nach Grundjustierung und Programmierung der Vorrichtung und Montage der Probe, wird die Ätzung gestartet. Der gesamte Vorgang läuft jetzt automatisch ab; typische Ätzzeiten liegen zwischen 10 Minuten und 24 Stunden.

### Zusammenfassend läßt sich das Verfahren also wie folgt fassen:

Zum Ätzen großflächiger Halbleiterscheiben wird in einer trogförmigen Aufnahme mit einem flüssigen Elektrolyten, mit wenigstens einem Probenkopf **12** innerhalb eines beweglich gelagerten Ätztrogs **10,** der mit einer Einrichtung zum Halten wenigstens einer Halbleiterscheibe **32** versehen ist, durch eine Schaukeleinrichtung der Elektrolyten in Bewegung versetzt, wobei der Probenkopf **12** mit der zu ätzenden Fläche (Vorderseite) nach unten im Ätztrog angeordnet ist, und zur Einstellung unterschiedlicher Elektrolyt-Schichtdicken austauschbare Abstandsstücke für den Abstand Ätztrogboden-Probenkopf vorgesehen sind, und auf der Rückseite elektrische Kontakte für eine elektrochemische Ätzung angeordnet sind.

Vorteilhafterweise ist der Probenkopf fest am Trog befestigt ist, während der Ätztrog zur Durchführung von Kippbewegungen um wenigstens eine Achse verschwenkbar ist und / oder sind weiter Kanäle zur turbulenten Umwälzung des Elektrolyten am Boden des Ätztrogs **10** und/oder an der Unterseite des Probenkopfes **12** vorgesehen sind.

Am Probenkopf **12** kann ein austauschbarer Montageblock **30** oberhalb der Halbleiterscheibe **32** angeordnet sein, der mit Randfugen versehen ist, die über eine Vakuumleitung **38** evakuierbar sind und die gegenüber dem Elektrolyten durch Ringdichtungen **28** am Randbereich der Halbleiterscheibe abgedichtet sind.

Eine bevorzugt verwandte Platin-Gegenelektrode **16** am Boden des Ätztrogs mit Platindrähten **22,** die an der Innenseite des Ätztrogs aufsteigend über dessen Kante führen, kontaktiert ist, und die Halbleiterscheibe an ihrer (Ober-/)Rückseite über Randkontakte kontaktierende ganzflächige Metallkontakte, durch eine mit ITO (Indium-Zinn-Oxid) beschichtete Glasplatte oder eine mit feinen Platindrähten umwickelte Plexiglasplatte kontaktiert werden, werden weiter vorgeschlagen.

Bevorzugt sollte wenigstens eine Temperatursteuerung zur Erwärmung und/oder Abkühlung des Elektrolyten mit Kühl-/ Heizkanälen an der Unterseite des Ätztrogs 12 vorgesehen sein. Am Ätztrog **10** sollte zudem zur Ausbildung einer Überdruckatmosphäre über dem Elektrolyten ein Deckel vorgesehen sein, der mit Zu- und Abführungen für Schutzgas versehen ist.

Im Ätztrog kann dann noch ein vom Elektrolyten benetzter Ort zur Anordnung von Trocknungsmittel vorgesehen ist, das dem Elektrolyten Wasserspuren zu entziehen vermag. Sofern der Montageblock **30** optisch durchlässig ist kann an seiner Oberseite ein Diodenarray **40** als Beleuchtung oberhalb einer gegen das den Montageblock umgebenden Vakuums abdichtenden durchsichtigen Platte **42** angeordnet werden.

Dadurch kann eine turbulenten Anströmung unterschiedlich viskoser Elektrolyten an den zu ätzenden Halbleiterscheiben **32** durch angepasste Bewegung des Ätztrogs und Einjustierung des Abstands Halbleiterscheibe zum Ätztrogboden über das vorherige Einsetzen geeigneter Abstandsstücke **26** zwischen diesen erzeugt werden.

Während des Ätzens sollte dann bevorzugt fortschreitende Zugabe von hochkonzentriertem Elektrolyten zur Beibehaltung der Elektrolytkonzentration erfolgen, wobei der Elektrolyt mit zugesetztem Trocknungsmittel versetzt sein kann.

Die Rückseite schließlich kann alternativ mit einem über die Beleuchtungsfläche scannenden Laserstrahl beleuchtet werden.

Die beigefügte Tabelle gibt beispielhaft Parametersätze für einige wenige der möglichen Porenätzungen an.

**ANLAGE: TABELLE 1**

| ***Einige typische Parametersätze*** | | | | | | | | |
|---|---|---|---|---|---|---|---|---|
| **Material** | **p-Silizium** | | | **n-Si** | **n⁺-Si** | **n-GaAs** | **n-InP** | |
| **Porenart** | makro | mikro | trench | makro | makro | crysto | crysto | curro |
| **Elektrolyt** | Org | Aqu/Fa | Org | Aqu M-Org | Aqu/ HMPA | Aqu | Aqu | Aqu |
| **Temp.** | 20°C | 20°C | 20°C | 14°C | 20°C | 20°C | 20°C | 20°C |
| *j* **[A/cm²]** | 0.002 | 0.025 | 0.0005 | 0.002-0.03 | 0.002-0.008 | <0.9 | <0.1 | 0.1-1 |
| *U*[V] | 2-16 | 20-40 | 1-2 | 1.4 | 1-2 | 20-90 | 20-60 | 30-90 |
| **Beleuchtg.** | nein | nein | nein | ja | nein | nein | nein | nein |
| **Kippfreq.** | 0.3Hz | 0.2Hz | | 0.3Hz | 0.2Hz | 0.8Hz | 0.3Hz | 0.8Hz |
| **Kippwinkel** | 8° | 8° | 8° | 8° | 5° | 4° | 8° | 3° |
| **Spaltbreite** | 10mm | 8-11mm | 8mm | 10mm | 8-10mm | 6mm | 8mm | 5 mm |

**Tabelle 1** Die Abkürzungen bedeuten:
Makro, meso, mikro = Makro-, Meso-, Mikroporen nach IUTPC,
Crysto, Curro = "crystallogaphically" bzw. "current-line oriented" Poren,
*j* = Stromdichte,
*U* = Spannung.
Bei Elektrolyten bedeutet:
Org = organischer Elektrolyt,
Aqu = wässriger Elektrolyt.

## Patentansprüche

1. Vorrichtung zum Ätzen großflächiger Halbleiterscheiben in einer trogförmigen Aufnahme mit einem flüssigen Elektrolyten, mit
a) wenigstens einem Probenkopf (12) innerhalb eines beweglich gelagerten Ätztrogs (10), der mit einer Einrichtung zum Halten wenigstens einer Halbleiterscheibe (32) versehen ist,
b) einer den Elektrolyten in Bewegung versetzende Schaukeleinrichtung,
c) wobei der Probenkopf (12) mit der zu ätzenden Fläche nach unten im Ätztrog (10) angeordnet ist,
d) zur Einstellung unterschiedlicher Elektrolyt-Schichtdicken austauschbaren Abstandsstücken für den Abstand Ätztrogboden-Probenkopf (12), und
e) auf der Rückseite angeordneten elektrischen Kontakten für eine elektrochemische Ätzung.

2. Vorrichtung nach Anspruch 1, **dadurch gekennzeichnet, daß** der Probenkopf fest am Trog befestigt ist, während der Ätztrog zur Durchführung von Kippbewegungen um wenigstens eine Achse verschwenkbar ist.

3. Vorrichtung nach einem der vorangehenden Ansprüche, **dadurch gekennzeichnet, daß** Kanäle zur turbulenten Umwälzung des Elektrolyten am Boden des Ätztrogs (10) und/oder an der Unterseite des Probenkopfes (12) vorgesehen sind.

4. Vorrichtung nach einem der vorangehenden Ansprüche, **dadurch gekennzeichnet, daß** am Probenkopf (12) ein austauschbarer Montageblock (30) oberhalb der Halbleiterscheibe (32) angeordnet ist, der mit Randfugen versehen ist, die über eine Vakuumleitung (38) evakuierbar sind und die gegenüber dem Elektrolyten durch Ringdichtungen (28) am Randbereich der Halbleiterscheibe abgedichtet sind.

5. Vorrichtung nach einem der vorangehenden Ansprüche, **dadurch gekennzeichnet, daß** eine Platin-Gegenelektrode (16) am Boden des Ätztrogs mit Platindrähten (22), die an der Innenseite des Ätztrogs aufsteigend über dessen Kante führen, kontaktiert ist, und die Halbleiterscheibe an ihrer (Ober-/)Rückseite über Randkontakte, ganzflächige Metallkontakte, durch eine mit ITO (Indium-Zinn-Oxid) beschichtete Glasplatte oder eine mit feinen Platindrähten umwickelte Plexiglasplatte kontaktiert ist.

6. Vorrichtung nach einem der vorangehenden Ansprüche, **dadurch gekennzeichnet, dass** wenigstens eine Temperatursteuerung zur Erwärmung und/oder Abkühlung des Elektrolyten mit Kühl-/ Heizkanälen an der Unterseite des Ätztrogs (12) vorgesehen ist.

7. Vorrichtung nach einem der vorangehenden Ansprüche, **dadurch gekennzeichnet, daß** am Ätztrog (10) zur Ausbildung einer Überdruckatmosphäre über dem Elektrolyten ein Dekkel vorgesehen ist, der mit Zu- und Abführungen für Schutzgas versehen ist.

8. Vorrichtung nach einem der vorangehenden Ansprüche, **dadurch gekennzeichnet, daß** im Ätztrog ein vom Elektrolyten benetzter Ort zur Anordnung von Trocknungsmittel vorgestehen ist, das dem Elektrolyten Wasserspuren zu entziehen vermag.

9. Vorrichtung nach einem der vorangehenden Ansprüche 5 bis 9, **dadurch gekennzeichnet, daß** der Montageblock (30) optisch durchlässig ist und an seiner Oberseite ein Diodenarray (40) als Beleuchtung oberhalb einer gegen das den Montageblock umgebenden Vakuums abdichtenden durchsichtigen Platte (42) angeordnet ist.

10. Verfahren zum Ätzen mit Elektrolyten in einer Vorrichtung nach den vorangehenden Ansprüchen, **gekennzeichnet durch** Erzeugen einer turbulenten Anströmung unterschiedlich viskoser Elektrolyten an den zu ätzenden Halbleiterscheiben (32) **durch** angepasste Bewegung des Ätztrogs und Einjustierung des Abstands Halbleiterscheibe zum Ätztrogboden über das vorherige Einsetzen geeigneter Abstandsstücke (26) zwischen diesen.

11. Verfahren nach Anspruch 12, **dadurch gekennzeichnet, daß** während der fortschreitenden Ätzung Zugabe von hochkonzentriertem Elektrolyten zur Beibehaltung der Elektrolytkonzentration erfolgt.

12. Verfahren nach einem der vorangehenden Ansprüche 11 - 12, **dadurch gekennzeichnet, daß** Elektrolyt mit zugesetztem Trocknungsmittel verwendet wird.

13. Verfahren nach einem der vorangehenden Ansprüche 11 - 13, **dadurch gekennzeichnet, daß** die Rückseite des Halbleiterscheibe mit einem über die Beleuchtungsfläche scannenden Laserstrahl beleuchtet wird.

14. Verfahren nach einem der vorangehenden Ansprüche 11 - 14, **dadurch gekennzeichnet, daß** die Rückseite der Halbleiterscheibe wenigstens lokal mit einem die Rückseite beleuchtenden Diodenarray beleuchtet wird.

15. Verfahren zum Ätzen mit Elektrolyten in einer Vorrichtung nach Anspruch 1, **gekennzeichnet durch** Erzeugen einer turbulenten Anströmung unterschiedlich viskoser Elektrolyten an den zu ätzenden Halbleiterscheiben (32) **durch** angepasste Horizontalbewegung des Kopfes im Becken und Einjustierung des Abstands der Halbleiterscheibe zum Ätztrogboden über das vorherige Einsetzen geeigneter Abstandsstücke (26) zwischen diesen.

## Claims

1. Apparatus for etching large-surface semiconductor wafers in a through-shaped receptacle with a liquid electrolyte, having
a) at least one sample head (12) inside an etching trough (10) that is mounted so as to be moveable and that is provided with a device for holding at least one semiconductor wafer (32),
b) a rocking device that sets the electrolyte into motion,
c) the sample head (12) being arranged with the surface to be etched facing down in the etching trough (10),
d) spacer elements for the distance between the etching-trough bottom and the sample head (12), that can be exchanged for setting different electrolyte layer thicknesses, and
e) electrical contacts arranged on the rear for electro-chemical etching.

2. Apparatus according to claim 1, **characterized in that** the sample head is firmly attached to the trough, while the etching trough can be swivelled for carrying out tilting movements about at least one axis.

3. Apparatus according to one of the preceding claims, **characterized in that** channels are provided for turbulently recirculating the electrolyte at the underside of the etching trough (10) and/or at the bottom of the sample head (12).

4. Apparatus according to one of the preceding claims, **characterized in that** an exchangeable mounting block (30) is arranged on the sample head (12) above the semiconductor wafer (32) and is provided with edge grooves that can be evacuated by means of a vacuum line (38) and that are sealed with respect to the electrolyte by edge seals (28) in the edge area of the semiconductor wafer.

5. Apparatus according to one of the preceding claims, **characterized in that** a platinum counter electrode (16) at the bottom of the etching trough is contacted by platinum wires (22) that lead, rising on the inside of the etching trough, over its edge and the semiconductor wafer is contacted on its (top/) rear by edge contacts, whole-surface metal contacts, by a glass pane coated with ITO (indium tin oxide) or by a plexiglass plate with fine platinum wires wrapped around it.

6. Apparatus according to one of the preceding claims, **characterized in that** at least one temperature control for heating and/or cooling the electrolyte with heating/cooling channels at the bottom of the etching trough (10) is provided.

7. Apparatus according to one of the preceding claims, **characterized in that** a lid is provided on the etching trough (10) for forming super-atmospheric pressure above the electrolyte and is provided with inlets and outlets for protective gas.

8. Apparatus according to one of the preceding claims, **characterized in that** a location wetted by the electrolyte is arranged in the etching trough for arranging a desiccant that is capable of extracting traces of water from the electrolyte.

9. Apparatus according to one of the preceding claims 5 to 9, **characterized in that** the mounting block (30) is optically transparent and that a diode array (40) is arranged at its top as illumination above a transparent plate (42) that seals against the vacuum surrounding the mounting block.

10. Method for etching with electrolytes in an apparatus according to the preceding claims, **characterized by** generating a turbulent inflow of electrolytes of varying viscosity at the semiconductor wafers (32) to be etched by a matched movement of the etching trough and adjusting the distance of the semiconductor wafer from the etching-trough bottom by previously inserting suitable distance elements (26) between these.

11. Method according to claim 12, **characterized in that** highly concentrated electrolyte is added as etching professes so as to maintain the electrolyte concentration.

12. Method according to one of the preceding claims 11 -12, **characterized in that** electrolyte with added desiccant is used.

13. Method according to one of the preceding claims 11 - 13, **characterized in that** the rear of the semiconductor water is illuminated with a laser beam scanning across the illumination surface.

14. Method according to one of the preceding claims 11 - 14, **characterized in that** the rear of the semiconductor wafer is illuminate at least locally by a diode array that illuminates the rear.

15. Method for etching with electrolytes in an apparatus according to claim 1, **characterized by** generating a turbulent inflow of electrolytes of varying viscosity at the semiconductor wafers (32) to be etched by a matched horizontal movement of the head in the basin and adjusting the distance of the semiconductor wafer from the etching-trough bottom by previously inserting suitable distance elements (26) between these.

## Revendications

1. Dispositif de gravure de tranches semi-conductrices de grande surface dans un réceptacle en forme de cuve contenant un électrolyte liquide, avec
a) au moins une tête porte-échantillon (12) à l'intérieur d'une cuve de gravure (10) montée mobile, qui est pourvue d'un équipement pour maintenir au moins une tranche semi-conductrice (32),
b) un équipement à bascule qui met l'électrolyte en mouvement,
c) la tête porte-échantillon (12) étant disposée avec la surface à graver vers le bas dans la cuve de gravure (10),
d) des pièces d'écartement échangeables pour la distance fond de cuve de gravure-tête porte-échantillon (12) pour régler différentes épaisseurs de couche d'électrolyte, et
e) des contacts électriques disposés sur la face arrière pour une gravure électrochimique.

2. Dispositif selon la revendication 1, **caractérisé en ce que** la tête porte-échantillon est fixée rigidement à la cuve tandis que la cuve de gravure peut pivoter autour d'au moins un axe pour effectuer des mouvement de basculement.

3. Dispositif selon l'une des revendications précédentes, **caractérisé en ce qu'**il est prévu des canaux pour faire circuler l'électrolyte de manière turbulente sur le fond de la cuve de gravure (10) et/ou sur la face inférieure de la tête porte-échantillon (12).

4. Dispositif selon l'une des revendications précédentes, **caractérisé en ce que** sur la tête porte-échantillon (12), au-dessus de la tranche semi-conductrice (32), est disposé un bloc de montage (30) échangeable qui est pourvu de joints périphériques qui peuvent être mis au vide par l'intermédiaire d'une conduite de vide (38) et qui sont rendus étanchés vis-à-vis de l'électrolyte par des joints d'étanchéité annulaires (28) dans la zone de bord de la tranche semi-conductrice.

5. Dispositif selon l'une des revendications précédentes, **caractérisé en ce qu'**une contre-électrode en platine (16) est contactée au fond de la cuve de gravure par des fils en platine (22) qui montent le long du côté intérieur de la cuve de gravure et passent par-dessus son bord, et la tranche semi-conductrice contactée à sa face (supérieure/) arrière, par l'intermédiaire de contacts périphériques, de contacts métalliques en pleine surface, par une plaque de verre revêtue d'ITO (oxyde d'indium-étain) ou une plaque de plexiglas enveloppée de fins fils en palatine.

6. Dispositif selon l'une des revendications précédentes, **caractérisé en ce qu'**il est prévu au moins une commande de température pour réchauffer et/ou refroidir l'électrolyte avec des canaux de refroidissement/chauffage sur la face inférieure de la cuve de gravure (12).

7. Dispositif selon l'une des revendications précédentes, **caractérise en ce que** sur la cuve de gravure (10), il est prévu un couvercle pourvu d'amenées et d'évacuations de gaz protecteur pour former une atmosphère de surpression au-dessus de l'électrolyte.

8. Dispositif selon l'une des revendications précédentes, **caractérisé en ce que** dans la cuve de gravure, il est prévu un emplacement mouillé par l'électrolyte pour disposer un agent déshydratant capable de retirer des traces d'eau de l'électrolyte.

9. Dispositif selon l'une des revendications précédentes 5 à 9, **caractérisé en ce que** le bloc de montage (30) est optiquement transparent et qu'un réseau de diodes (40) servant d'éclairage est disposé sur sa face supérieure au-dessus d'une plaque transparente (42) assurant l'étanchéité par rapport au vide entourant le bloc de montage.

10. Procédé de gravure au moyen d'électrolytes dans un dispositif selon les revendications précédentes, **caractérisé par** la génération d'un afflux turbulent d'électrolytes de viscosité différente sur les tranches semi-conductrices (32) à graver par déplacement adapté de la cuve de gravure et ajustement de la distance entre tranche semi-conductrice et fond de cuve de gravure moyennant l'utilisation préalable de pièces d'écartement (26) appropriées entre ceux-ci.

11. Procédé selon la revendication 12, **caractérisé en ce que** pendant la progression de la gravure, de l'électrolyte hautement concentré est ajouté pour maintenir la concentration de l'électrolyte.

12. Procédé selon l'une des revendications précédentes 11 à 12, **caractérisé en ce que** l'on utilise de l'électrolyte avec agent déshydratant ajouté.

13. Procédé selon l'une des revendications précédentes 11 à 13, **caractérisé en ce que** la face arrière de la tranche semi-conductrice est éclairée avec un faisceau laser balayant la surface d'éclairage.

14. Procédé selon l'une des revendications précédentes 11 à 14, **caractérisé en ce que** la face arrière de la tranche semi-conductrice est éclairée au moins localement par un réseau de diodes éclairant la face arrière.

15. Procédé de gravure au moyen d'électrolytes dans un dispositif selon la revendication 1, **caractérisé par** la génération d'un afflux turbulent d'électrolytes de viscosité différente sur les tranches semi-conductrices (32) à graver par déplacement horizontal adapté de la tête dans la cuve et ajustement de la distance entre tranche semi-conductrice et fond de cuve de gravure moyennant l'utilisation préalable de pièces d'écartement (26) appropriées entre ceux-ci.
